# EUROPÄISCHE PATENTANMELDUNG

(11) **EP 1 555 534 A1**
(43) Veröffentlichungstag der Anmeldung: **20.07.2005**
(21) Anmeldenummer: 04029047.0
(22) Anmeldetag: 08.12.2004
(51) Int. Cl.: G01R 21/133, H04B 3/54, H02J 13/00

(54) **Elektronischer Elektrizitätszähler mit Rundsteuerempfänger**

(30) Priorität: 16.01.2004 DE 102004002189
(71) Anmelder: EMH Elektrizitätszähler GmbH & Co KG, 19243 Wittenburg (DE)
(72) Erfinder: Malek, Norbert, 21438 Thieshope (DE)
(74) Vertreter: Graalfs, Edo, Dipl.-Ing.

(57) **Zusammenfassung**

Elektronischer Elektrizitätszähler mit mindestens einem AD-Wandler für Strom und Spannung (14), dessen Ausgang mit einem Mikrorechner (12) verbunden ist, wobei der Mikrorechner eine Stufe für die Berechnung von Zählwerten, ein an die Stufe angeschlossenes Tarifwerk, einen Ausgang für eine Anzeige, Eingänge für eine Bedienung und eine Programmierung sowie ggf. mindestens einen Steuerausgang und einen Kommunikationsausgang aufweist, ferner mit einem Rundsteuerempfänger, der Mittel aufweist zur Filterung und Auswertung von Rundsteuertelegrammen zwecks Auslösung von Steuervorgängen im Elektrizitätszähler, wobei in der Soft- und Hardware des Mikrorechners des Elektrizitätszählers ein digitales Filter (16) für den Rundsteuerempfänger realisiert ist, das mit dem Ausgang des Spannungs-AD-Wandlers verbunden ist, daß ein Frequenz-Impulswandler (18) für den Ausgang des digitalen Filters vorgesehen ist und eine Vergleichstufe (20) für den Vergleich des Ausgangs der Frequenz-Impulswandlerstufe mit einem gespeicherten Telegramm zwecks Auslösung mindestens eines Steuervorgangs.

## Beschreibung

Die Erfindung bezieht sich auf einen elektronischen Elektrizitätszähler nach dem Patentanspruch 1 sowie auf einen Rundsteuerempfänger für einen Elektrizitätszähler nach Patentanspruch 2.

In der Elektrizitätswirtschaft ist bekannt, mittels Fernwirktechnik an Anlagen Schalthandlungen vorzunehmen, so auch bei Elektrizitätszählern. Bei Elektrizitätszählern dienen die Schalthandlungen zum Beispiel der Tarifsteuerung.

In der Fernwirktechnik ist seit langem bekannt, die sogenannte Tonfrequenz-Rundsteuertechnik zu verwenden. Hierzu werden niederfrequente Signale der Spannung auf den Versorgungsleitungen überlagert. Der Frequenzbereich der Steuersignale liegt üblicherweise zwischen 100 und 1400 Hz. Der Pegel der Steuersignale beträgt am Empfangsort typischerweise 1 bis 5 Prozent der Netznennspannung.

Die Steuersignale werden in Form von sogenannten Rundsteuertelegrammen von einer Zentrale versandt. Rundsteuertelegramme bestehen aus einer Anzahl von Rundsteuerimpulsen und Impulspausen. Um am Empfangsort ein Ereignis hervorzurufen, muß das Rundsteuertelegramm von einem Rundsteuerempfänger erkannt werden. Hierzu wird das Rundsteuersignal mittels eines Filters von der Netzspannung getrennt. Die Telegrammparameter werden auf Übereinstimmung mit dem im Rundsteuerempfänger hinterlegten Telegramm geprüft. Bei Übereinstimmung findet das gewünschte Schalt- oder Steuerereignis statt.

Üblicherweise werden Rundsteuerempfänger mittels digitaler Technik realisiert. Das zu filternde Signal wird einem Analog-Digitalwandler zugeführt, digitalisiert und anschließend digital gefiltert. Das Digitalfilter wird in Form von Software-Algorithmen programmiert. Die Impuls- und Telegrammprüfung findet ebenfalls digital im Rundsteuerempfänger statt.

Es ist bereits bekannt, Rundsteuerempfänger in Elektrizitätszählern anzuordnen, um dort bestimmte Tarifschalthandlungen vorzunehmen. Nachteil ist, daß innerhalb des Elektrizitätszählers zusätzlicher Raum für den Empfänger benötigt wird. Es ist ein zusätzlicher Mikrorechner erforderlich, der den Elektrizitätszähler aufwendiger macht. Auch steigt der Energiebedarf des Elektrizitätszählers. Ein weiterer Nachteil ist darin zu sehen, daß ein weiterer Aufwand im Elektrizitätszähler betrieben werden muß, um den Rundsteuerempfänger mit seinen Schnittstellen an den vorhandenen Mikroprozessor, Mikrorechner oder digitalen Signalprozessor anzukoppeln. Die Ankopplung benötigt Schnittstellen in Form von Hardware und Software.

Elektronische Elektrizitätszähler verwenden Analog-Digitalwandler sowohl für den Strom als auch für die Spannung. Ein Mikrorechner des Elektrizitätszählers enthält eine Stufe für die Berechnung der dem Netz entnommenen Energie, ein Tarifwerk sowie Schnittstellen für Bedienelemente, Kommunikationsanschlüsse, Steuerausgänge für Eingangs- und Ausgangssteuerbefehle. Optional kann auch eine Tarifschaltuhr im Mikrorechner vorgesehen werden.

Der Erfindung liegt die Aufgabe zugrunde, einen Elektrizitätszähler zu schaffen, der bei einer Ansteuerungsmöglichkeit durch Fernwirktechnik, insbesondere durch Rundsteuertechnik, gleichwohl weniger aufwendig hergestellt werden kann. Diese Aufgabe wird durch die Merkmale der Patentansprüche 1 und 2 gelöst.

Bei dem elektronischen Elektrizitätszähler nach Anspruch 1 wird in der Soft- und Hardware des Mikrorechners des Elektrizitätszählers ein digitales Filter realisiert, das mit dem Ausgang des AD-Wandlers für die Spannung verbunden ist. Ferner enthält die Software einen Frequenz-Impulswandler, der mit dem Ausgang des digitalen Filters verbunden ist und eine Vergleichsstufe für den Vergleich des Ausgangs der Frequenz-Impulswandlerstufe mit einem gespeicherten Telegramm. Der Mikrorechner enthält ferner eine Stufe zur Auslösung von gewünschten Steuer- und Schaltvorgängen im Elektrizitätszähler.

Alternativ ist es gemäß Patentanspruch 2 auch möglich, die elektronischen Komponenten, die bezüglich der Hardware und Software eines elektronischen Elektrizitätszählers mindestens vorhanden sein müssen, in einen elektronischen Rundsteuerempfänger zu integrieren, indem der Mikrorechner des Rundsteuerempfängers ein Rechenwerk für die aus dem Netz bezogene Energie, ein Tarifwerk und ggf. Schnittstellen für eine Anzeige, Bedienelemente, Kommunikation, ein- und ausgehende Steuersignale und so weiter aufweist. Die Lösung nach Patentanspruch 2 bietet sich vor allen Dingen dann an, wenn eine relativ einfache Zählersoftware gefordert ist, beispielsweise in einem einfachen Tarifzähler.

Erfindungsgemäß werden die Abtastwerte des im Elektrizitätszählers ohnehin vorhandenen Analog-Digitalwandlers für die Spannung verwendet, um mit Hilfe des digitalen Filters die Rundsteuersignale aus dem Meßsignal herauszufiltern. Der Aufwand, der bei einem derartigen Elektrizitätszähler erforderlich ist, ist gegenüber den herkömmlichen Elektrizitätszählern ohne Fernansteuerung minimal erhöht, da nur eine einzige Software programmiert werden muß.

Die Erfindung wird nachfolgend anhand eines in Zeichnungen dargestellten Ausführungsbeispiels näher erläutert.
- Fig. 1: zeigt die Schaltungsanordnung eines elektronischen Rundsteuerempfängers.
- Fig. 2: zeigt die Schaltungsanordnung eines elektronischen Zählers mit einem Rundsteuersystem gemäß Fig. 1.

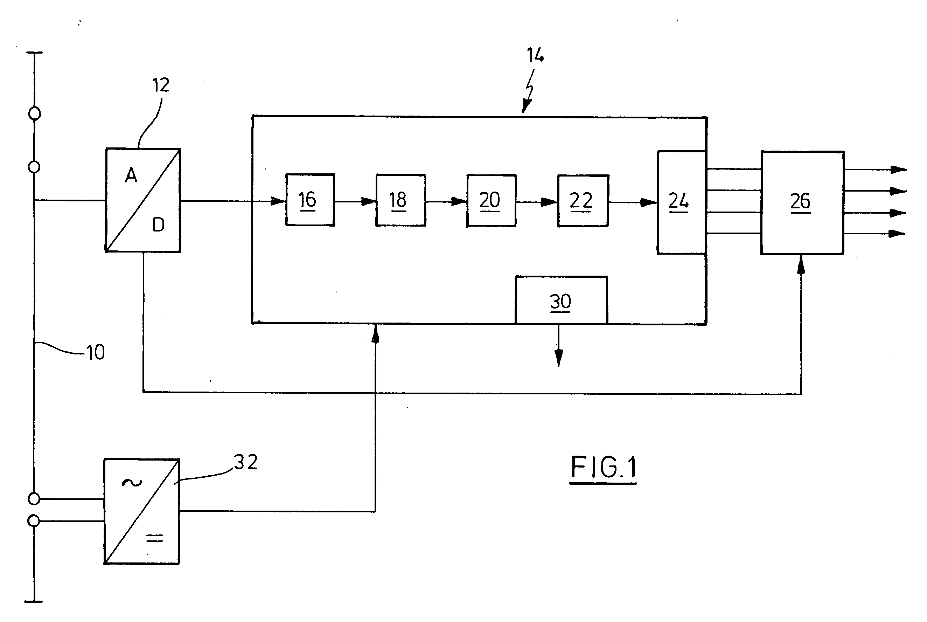

In Fig. 1 ist über eine Spannungsanpassung ein Analog-Digitalwandler 12 mit einem bei 10 angedeuteten Netz verbunden. Der Ausgang des Analog-Digitalwandlers wird mit einem Mikrorechner 14 verbunden, in dem folgende Stufen realisiert sind: ein digitales Filter 16, ein Frequenz-Impulswandler 18, eine Vergleichsstufe 20 und ein Schaltwerk 22. Diese sind, wie gezeigt, hintereinander geschaltet. Der Ausgang des Schaltwerks geht auf eine Schnittstelle 24 für Schaltelemente, welche durch die Stufe 26 angedeutet sein sollen. Eine weitere Schnittstelle 30 ist eine sogenannte Kommunikationsschnittstelle. Ein Netzteil 32 versorgt die einzelnen Baugruppen mit Spannung.

Die Netzspannung des Netzes 10 wird im Analog-Digitalwandler 12 digitalisiert und in dem digitalen Filter 16 gefiltert und in der Frequenz-Impulswandlerstufe 18 in Impulse umgewandelt, welche in der Vergleichsstufe 20 mit einer hinterlegten Impulsreihe verglichen werden. Wird Übereinstimmung festgestellt, steuert das elektronische Schaltwerk 22 über die Schnittstelle 24 die Schaltelemente 26 an. Fig. 1 stellt mithin einen Rundsteuerempfänger dar, mit dem auf die Netzspannung modulierte Spannungssignale höherer Frequenz und kleinerer Amplitude ausgewertet und verarbeitet werden können.

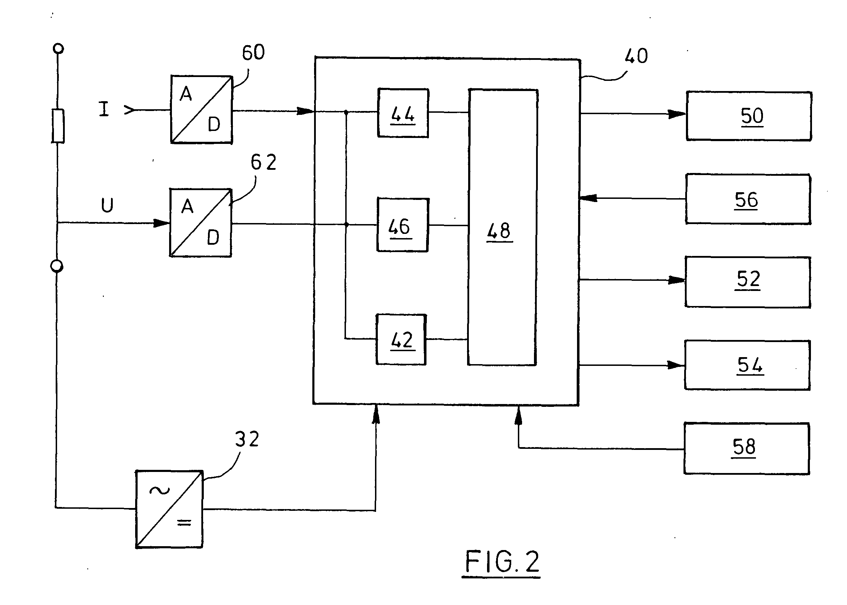

Fig. 2 zeigt die Anwendung eines Rundsteuerempfängers gemäß Fig. 1 auf einen Elektrizitätszähler als Einphasenzähler. Ein Mikrorechner 40 realisiert in der Stufe 42 den Rundsteuerempfänger mit den Stufen 16 bis 20 des Mikrorechners 14 nach Fig. 1. Der Mikrorechner 40 enthält ferner eine Stufe 44 für die Berechnung der Zählwerte (Energie, Leistung, I, U.), eine Tarifschaltuhr 46 sowie ein Tarifwerk 48, das mit den drei Stufen 44, 46 und 42 verbunden ist. Der Mikrorechner 40 weist eine Reihe von Ausgängen und Eingängen auf. Ein Ausgang ist mit einer Anzeige 50 verbunden. Ein weiterer Ausgang ist mit einer Kommunikationseinheit 52 (Programmierung und Datenauslesung) verbunden. Ein dritter Ausgang ist mit einem Steuersignalgeber 54 verbunden, wobei die Steuersignale vom Mikrorechner 40 kommen. Ein erster Eingang ist mit einer Bediensteuerung 56 verbunden und zweiter Eingang mit einem Steuersignalgeber 58 zum Ansteuern des Mikrorechners 40. Man erkennt, daß die Bausteine, die hard- und softwaremäßig für einen Rundsteuerempfänger erforderlich sind, in dem Mikrorechner bzw. die Software für einen elektronischen Elektrizitätszähler integriert sind.

## Patentansprüche

1. Elektronischer Elektrizitätszähler mit mindestens einem AD-Wandler für Strom und Spannung, dessen Ausgang mit einem Mikrorechner verbunden ist, wobei der Mikrorechner eine Stufe für die Berechnung von Zählwerten, ein an die Stufe angeschlossenes Tarifwerk, einen Ausgang für eine Anzeige, Eingänge für eine Bedienung und eine Programmierung sowie ggf. mindestens einen Steuerausgang und einen Kommunikationsausgang aufweist, ferner mit einem Rundsteuerempfänger, der Mittel aufweist zur Filterung und Auswertung von Rundsteuertelegrammen zwecks Auslösung von Steuervorgängen im Elektrizitätszähler, **dadurch gekennzeichnet, daß** in der Soft- und Hardware des Mikrorechners (40) des Elektrizitätszählers ein digitales Filter für den Rundsteuerempfänger realisiert ist, das mit dem Ausgang des Spannungs-AD-Wandlers (62) verbunden ist, daß ein Frequenz-Impulswandler für den Ausgang des digitalen Filters vorgesehen ist und eine Vergleichstufe für den Vergleich des Ausgangs der Frequenz-Impulswandlerstufe mit einem gespeicherten Telegramm zwecks Auslösung mindestens eines Steuervorgangs.

2. Rundsteuerempfänger für Elektrizitätszähler mit einem Mikrorechner, der einen an das Netz angeschlossenen AD-Wandler, ein digitales Filter und eine Frequenz-Impulswandlerstufe zur Separierung eines über das Netz gesendeten Rundsteuertelegramms, eine Vergleichsstufe für den Vergleich des Rundsteuertelegramms mit einem gespeicherten Telegramm, eine Steuerstufe sowie eine Schnittstelle für Schaltelemente und/oder für Steuer- und Zustandsdaten aufweist, **dadurch gekennzeichnet, daß** der Mikrorechner eine Stufe für die Berechnung der aus dem Netz bezogenen Energie und ein Tarifwerk aufweist.

3. Rundsteuerempfänger nach Anspruch 1 oder 2, **dadurch gekennzeichnet, daß** der Mikrorechner eine Schnittstelle für eine Aussage und/oder für Bedienelemente und/oder für Eingangs- und/oder Ausgangssignale und/oder eine Tarifschaltuhr aufweist.
